# EUROPEAN PATENT APPLICATION

(11) **EP 0 730 298 A2**
(43) Date of publication of application: **04.09.1996**
(21) Application number: 96102974.1
(22) Date of filing: 28.02.1996
(51) Int. Cl.: H01L 23/532, H01L 21/768

(54) **A dielectric, a manufacturing method thereof, and semiconductor device using the same**

(30) Priority: 28.02.1995 JP 39687/95
(71) Applicant: HITACHI, LTD., Chiyoda-ku, Tokyo 101 (JP)
(72) Inventor: Fukuda, Takuya, Kodaira-shi, Tokyo 187 (JP); Kanai, Fumiyuki, Houya-shi, Tokyo 202 (JP); Kato, Kiyotaka, Kodaira-shi, Tokyo 187 (JP)
(74) Representative: Beetz & Partner Patentanwälte

(57) **Abstract**

A silicon oxide fluoride film having Si-F bonds and Si-O bonds is used for dielectric insulators for the wiring of semiconductor devices. Dielectric films are formed using SiF₂X₂ gas (X = H, Cl, Br, OCH₃, OC₂H₅, and OC₃H₅) as a reactant.

Using this dielectric, semiconductor devices having a small wiring delay and high reliability can be manufactured, because the silicon oxide fluoride film having Si-F bonds and Si-O bonds has a smaller dielectric constant than a silicon oxide fluoride film having Si-Si bonds and O-F bonds.

## Description

### Background of the Invention

The present invention relates to a dielectric, a manufacturing method thereof, and a semiconductor device, especially to a dielectric with a low dielectric constant suitable for moderating wiring delay of signals and improving durability of semiconductor integrated circuits and the like.

In accordance with the conventional manufacturing process for semiconductor devices, a trial for moderating the wiring delay of signals has been performed, and is as follows. The signals are transmitted through wiring, and an organic film with a low dielectric constant is used to insulate the wiring. However, the insulation of the wiring by the organic film is hardly used because of problems with the durability of the organic film.

Currently, to improve durability, methods for preparing dielectric films composed of silicon, oxygen, and fluorine (called SiOF films hereinafter) have been developed, for instance, the method using silicon tetrafluoride (SiF₄) and oxygen as reacting gases, as disclosed in "Preparation of SiOF Films with Low Dielectric Constant by ECR Plasma Chemical Vapor Deposition" p.158, Extended Abstract of the 1993 Conference on Solid State Devices and Materials (1993). Further, another method of adding gases from the fluorine group to the gases necessary for forming a silicon oxide film is disclosed in "Formation Mechanism of F-added SiO₂ Films using Plasma CVD" p.133, The 16th Proceedings of Symposium on Dry Process (1994).

In connection with the conventional SiOF films, the fluctuation in the dielectric constant of the films, is so large that it is not possible to form films with a low dielectric constant. Further, the humidity resistence of the films is low.

The present invention has been developed with consideration of the above problems.

It is the underlying problem of the present invention to provide new SiOF dielectrics, methods for manufacturing these dielectrics, and their use, particularly for or in semiconductor devices.

The above problem is solved according to the independent claims. The dependent claims relate to prefered embodiments of the concept of the present invention.

### Summary of the Invention

The dielectric according to the present invention comprises one or more silicon oxide fluoride compounds, having covalent bonds of fluorine atoms and silicon atoms.

Further, in accordance with a method for manufacturing the dielectric according to the present invention, an SiOF film is formed by supplying an amount of energy to a gas which contains SiF₂X₂ which does not dissociate the covalent bonds of fluorine atoms and the silicon atoms of the SiF₂X₂.

Furthermore, in accordance with the semiconductor device according to the present invention, dielectric bodies comprising silicon oxide fluoride compounds, having covalent bonds of fluorine atoms and silicon atoms, are provided between a plurality of wirings which are located on the substrate of the semiconductor device.

The dielectric constant of a substance is the sum of components based on orientation polarization, ionic polarization, and electronic polarization. The main component of the dielectric constant of a non-oriented substance such as an SiO₂ or SiOF film is almost the same as the dielectric constant based on electronic polarization. The dielectric constant based on the electronic polarization can be obtained from the atomic refraction of the constituent atoms, or the electronic group refraction of the bonds between the atoms.

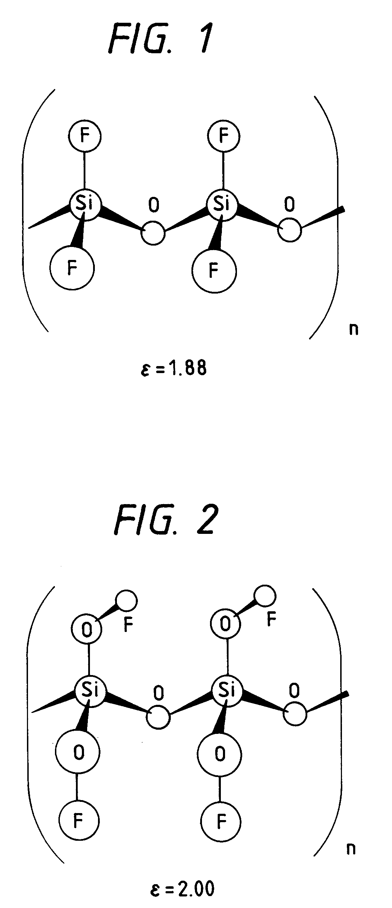

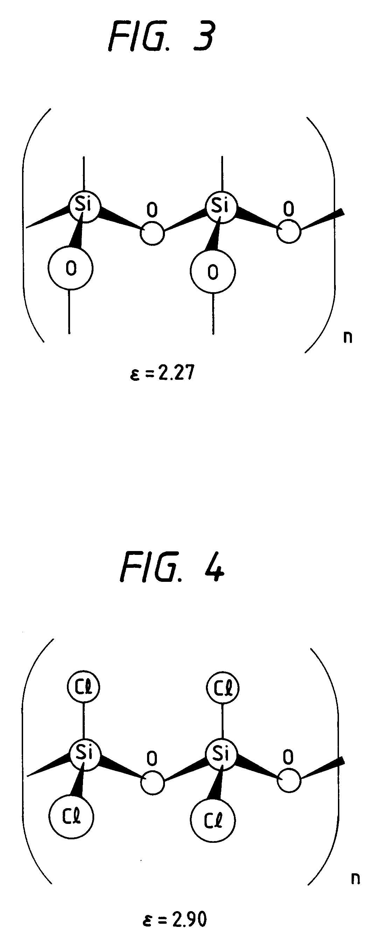

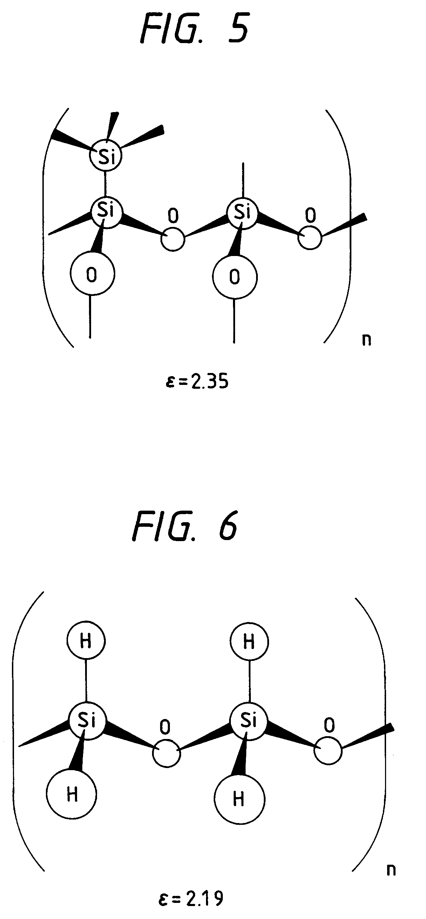

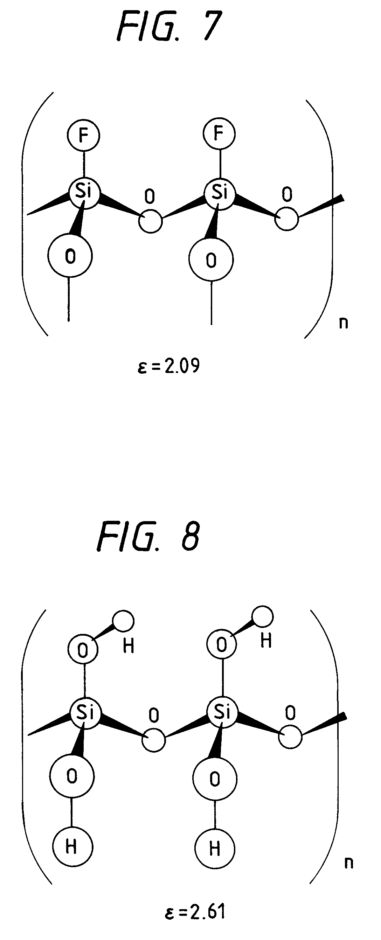

Fig. 1 illustrates the molecular structure of an SiOF film according to the present invention, and Figs. 2-8 illustrate molecular structures of conventionally known films of SiO, SiO₂, or SiOX (X = OF, H, OH, Cl). In said Figs. 2-8, the specific dielectric constants ε are shown calculated from the respective atomic refractions. The atomic fraction of F is calculated by subtracting the atomic refraction of C from the molecular refraction of CF₄. The atomic fraction of Si is calculated by subtracting the atomic refraction of F from the molecular refraction of SiF₄. The specific dielectric constant ε of the SiOF film is smaller than that of SiO and SiO₂ films as shown in Figs. 2-8. Furthermore, in accordance with the present invention, the dielectric constant ε of the molecular structure of SiOF films having covalent Si-F bonds is smaller than that of the molecular structure of SiOF films having the covalent Si-O bonds.

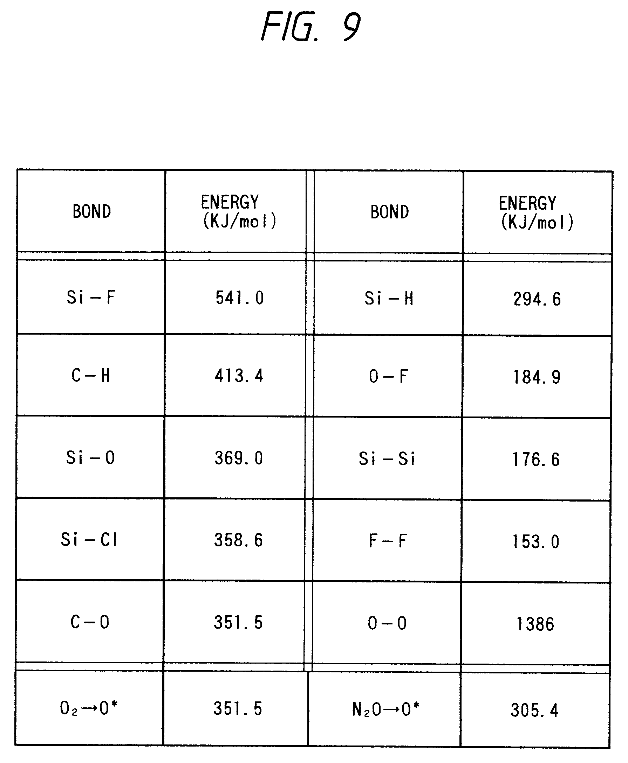

Fig. 9 shows dissociation energies of various bonds. The O-F bond is weaker than the Si-F bond by approximately 1/3. Therefore, an SiOF film having Si-F bonds has a smaller ε and is chemically more stable than an SiOF film having O-F bonds.

In order to form an SiOF film with a molecular structure having Si-F bonds, SiF₂X₂ molecules are used, These molecules have at least two Si-F bonds and another two Si-X bonds, X being an atom or an atomic group. The Si-X bonds have a smaller bond energy than Si-F bond energy. As shown in Fig. 9, bond energies of Si-H, Si-Cl, Si-O bonds are smaller than the bond energy of Si-F bonds. Accordingly, molecules of Si-X wherein X is any of H, Cl, OCH₃, OC₂H₅, OC₃H₇, and the like are preferable.

When using SiF₂X₂ molecules wherein the bond energy of the Si-X bond is smaller than the bond energy of the Si-F bond, conditions can be establised under which the Si-F bonds are kept unchanged but the Si-X bonds dissociate.

In practice, the reaction temperature of a thermal CVD apparatus or the input power of a plasma treating apparatus are controlled so as to bring up 541 kJ per one mole of SiF₂X₂ molecule, wherein the Si-F bonds do not dissociate. In the above case, oxygen is combined with the Si atom which has two Si-F bonds, and the X atoms dissociate. Furthermore, residual uncombined oxygen valences form a bond with a similar Si in another SiF₂X₂ molecule. Accordingly, SiOF films having a molecular structure wherein F is combined with Si as shown in Fig. 1 can be formed.

As shown in Fig. 9, the bond energy of the Si-H bond is smaller than the bond energies of Si-Cl, and Si-O bonds. Therefore, using a molecule of Si-X wherein the X is H, the margins of the operating conditions can be extended.

### Brief Description of the Drawings

Fig. 1 illustrates schematically the molecular structure of an SiOF film of the present invention,
Fig. 2 illustrates schematically the molecular structure of a conventional SiO(OF) film,
Fig. 3 illustrates schematically the molecular structure of a conventional SiO₂ film,
Fig. 4 illustrates schematically the molecular structure of a conventional SiOCl film,
Fig. 5 illustrates schematically the molecular structure of a conventional SiO film,
Fig. 6 illustrates schematically the molecular structure of a conventional SiOH film,
Fig. 7 illustrates schematically the molecular structure of a conventional SiOF film,
Fig. 8 illustrates schematically the molecular structure of a conventional SiO(OH) film,
Fig. 9 indicates dissociation energies of various bonds,
Fig. 10 is a schematic cross-section of an ECR-CVD apparatus used in the present invention for forming SiOF films,
Fig. 11 is an infrared absorption spectrum of the SiOF film of the present invention,
Fig. 12 is a schematic cross-section of a parallel plate type RF-CVD apparatus used in the present invention for forming SiOF films,
Fig. 13 is a schematic cross-section of an ICP-CVD apparatus used in the present invention for forming SiOF films,
Fig. 14 schematically illustrates a condition according to the present invention, wherein wires on a semiconductor substrate are covered with the SiOF film,
Fig. 15 schematically illustrates a condition according to the present invention, wherein wires on a semiconductor substrate are covered with the SiOF films, which are formed by overlapped sputtering,
Fig. 16 schematically illustrates a condition according to the present invention, wherein wires on a semiconductor substrate are covered with a planarized SiOF film,
Fig. 17 is a graph indicating the relationship between the dielectric constant and HWHH (Half Width at Half Height) of the SiOF film of the present invention,
Fig. 18 is a graph indicating the relationship between the specific dielectric constant and the density of the SiOF film of the present invention,
Fig. 19 is a graph indicating the relationship between the density and the dielectric breakdown electric field of the SiOF film of the present invention,
Fig. 20 is a graph indicating the relationship between the specific dielectric constant and the desorption amount according to the present invention,
Fig. 21 is a schematic cross-section of an SRAM according to the present invention, wherein the SiOF film is used,
Fig. 22 is a schematic cross-section of a DRAM according to the present invention, wherein the SiOF film is used, and
Fig. 23 is a plan view of a memory cell of the DRAM shown in Fig. 22.

### Description of the Preferred Embodiments

The present invention is explained in detail referring to the figures hereinafter.

### Embodiment 1

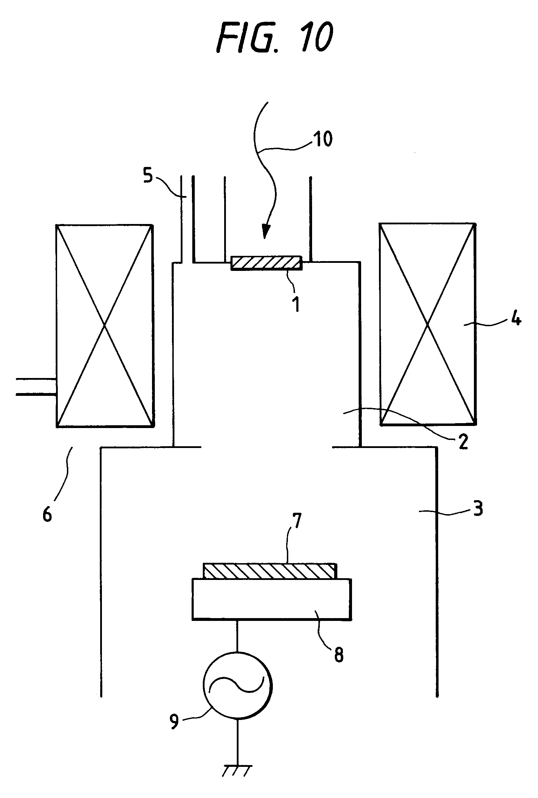

Fig. 10 is a schematic cross-section of an Electron Cyclotron Resonance (ECR)-CVD apparatus, which is one of CVD apparatus used for forming SiOF films. The apparatus comprises a plasma generating chamber 2 having a microwave introducing window 1, a reaction chamber 3, a magnetic field generating coil 4, reaction gas inlets 5 and 6, a holder 8 holding a substrate 7, and a high frequency power source for supplying high frequency waves to the substrate 7.

First, a process for forming an SiOF film using silicon tetrafluoride (SiF₄) and oxygen (O₂) gas is explained. From the reaction gas inlets 5 and 6, O₂ by 200 ml/min and SiF₄ by 40 ml/min are introduced respectively into the reaction chamber 3. The pressure in the reaction chamber 3 is adjusted at 0.2 Pa by controlling the amount of exhaust gas. The exhaust gas system is not shown in Fig. 10. A magnetic field of 0.0875 T is generated in the plasma generating chamber 2 by the magnetic field generating coil 4, and ECR plasma is generated by introducing microwaves of 2.45 GHz so that said SiOF film is formed on the surface of the substrate because of reaction between O₂ and SiF₄. In this case, a p-type Si substrate of 126 mm in diameter is used as the substrate. The introduced microwave power (Pµ) is 600 W.

The film depositing rate (D.R.) increases proportional to the introduced microwave power (P); for instance, D.R. is 0.2 µm/min at 600 W of Pµ. The specific dielectric constant ε of the formed film is approximately 3.5. The bonding conditions of the formed film are such that the Si-Si bonds are 10 % of the O-Si-O bonds, and the Si-O-F bonds are 30 % of the Si-F bonds. The specific dielectric constant ε can be measured by the formation of a aluminum electrode on the formed film. The bonding conditions of the formed film can be measured by means of fluorescent X ray (XPS) analysis or nuclear magnetic resonance (NMR) analysis.

Next, a method for forming an SiOF film by introducing silane difluoride (SiH₂F₂), according to an embodiment of the present invention, is explained. Conditions for forming SiOF film are the same as those above process which uses SiF₄. The film deposition rate does not depend on the introduced microwave power, but increases proportional to the amount of introduced SiH₂F₂ gas. When the SiH₂F₂ gas is introduced at a rate of 40 ml/min, the film deposition rate D.R. is equal to 0.38 µm/min, approximately twice of the rate when SiF₄ is used. The reason why the film deposition rate increases when using SiH₂F₂ gas is because the dissociation energy of SiH₂F₂ is lower than that of SiF₄.

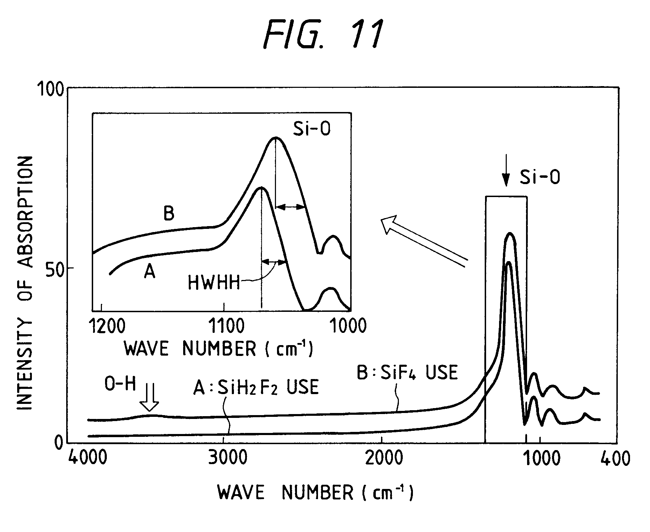

Fig. 11 indicates infrared absorption spectra of SiOF films formed by SiH₂F₂ and SiF₄, respectively. In the case of SiF₄ (hereinafter case: B), the center of the Si-O vibration is at 1065 cm⁻¹, and with said half width at half height (HWHH) at a lower wave number side is 33 cm⁻¹, although slight moisture (O-H) can be observed.

On the other hand, in the case of SiH₂F₂ (case: A), the center of the Si-O vibration is at 1080 cm⁻¹, and with said half width at half height (HWHH) at a lower wave number side is 24 cm⁻¹. A larger wave number indicates a stronger bond of Si-O, and a smaller WHWW indicates a simpler network with fewer kinds of bonds.

When the bonding condition is measured by fluorescent X ray (XPS) analysis and nuclear magnetic resonance (NMR) analysis, no Si-Si bonds and Si-O-F bonds can be observed. Accordingly, the structure of the film is mostly composed of Si-O bonds and Si-F bonds as shown in Fig. 1. The reason why O-H bonds are not observed in the infrared spectrum is because the structure does not contain weak Si-O-F bonds.

The ε of the formed film is approximately 3.2. The ε is a value obtained by multiplying an estimated ε (= 1.88) of SiOF film shown in Fig. 1 by a conversion ratio η (= 1.76) of ε of SiO₂ film (= 2.27), estimated from atomic refraction and ε of observed glassy SiO₂ (= 4.0).

As explained above, when the SiOF film is formed by introducing silane difluoride (SiH₂F₂), the deposition rate of the film increases, and the dielectric film having preferable chemical stability such as moisture-resistence and a low dielectric constant can be formed because the formed SiOF film is mostly composed of Si-O bonds and Si-F bonds.

### Embodiment 2

When a film is formed under the same conditions as in the above embodiment 1 except introducing silicon dichloride difluoride (SiF₂Cl₂) instead of SiH₂F₂, an SiOF film can be formed, wherein no Cl is observed. The deposition rate of the film is almost the same as the rate when SiH₂F₂ is used, and D.R. = 0.36 µm/min. The ε is approximately 3.3, which is slightly higher than that in the case of using SiH₂F₂. That means, when SiF₂Cl₂ is used, an insulator film having a lower dielectric constant than that of the insulator film obtained by using SiH₂F₂ can be formed.

Furthermore, when a film is formed under the same conditions as in the embodiment 1 except introducing silicon dibromide difluoride (SiF₂Br₂) instead of SiH₂F₂, an SiOF film, wherein no Br is observed, can be formed. The deposition rate of the film is almost the same as the rate in the case of using SiH₂Cl₂, and D.R. = 0.36 µm/min. Therefore, a dielectric film having a low dielectric constant ε such as approximately 3.3 can be formed.

### Embodiment 3

When a film is formed under the same conditions as in the embodiment 1 except introducing dimetoxy silicon difluoride (SiF₂(OCH₃)₂) instead of SiH₂F₂, an SiOF film, wherein no C is observed, can be formed. The deposition rate of the film is approximately the same as the rate in the case of using SiH₂F₂, and D.R. = 0.36 µm/min. The ε is slightly higher than in the case of using SiH₂F₂ and is approximately 3.3.

When a film is formed under the same conditions as in the embodiment 1 except introducing diethoxy silicon difluoride (SiF₂(OC₂H₅)₂) instead of SiH₂F₂, an SiOF film, wherein C is hardly observed, can be formed. The deposition rate of the film D.R. is 0.36 µm/min, and is slower than that in the case of using SiH₂F₂. The reason of the slower D.R. is because SiF₂(OC₂H₅)₂ has a lower vapor pressure at room temperature than SiH₂F₂. Therefore, if the temperature of the source vessel and the piping is elevated so as to make it possible to introduce the necessary amount of SiF₂(OC₂H₅)₂, 40 ml/min, the D.R. increases to 0.36 µm/min. The ε is approximately 3.3.

When a film is formed under the same conditions as in the embodiment 1 except introducing dipropoxy silicon difluoride (SiF₂(OC₃H₇)₂) instead of SiH₂F₂, an SiOF film can also be formed. However, the temperature of the source vessel and the piping must be elevated so as to make it possible to introduce the necessary amount of SiF₂(OC₃H₇)₂, 40 ml/min. In this case, the D.R. is 0.36 µm/min, and the ε is approximately 3.3.

In accordance with the study by the present inventors, the conditions of coating a substrate surface when the SiOF film is formed on the substrate having an uneven surface become more preferable depending on using source materials in the order of SiF₂(OC₃H₇)₂, SiF₂(OC₂H₅)₂, (SiF₂(OCH₃)₂), and SiH₂F₂.

### Embodiment 4

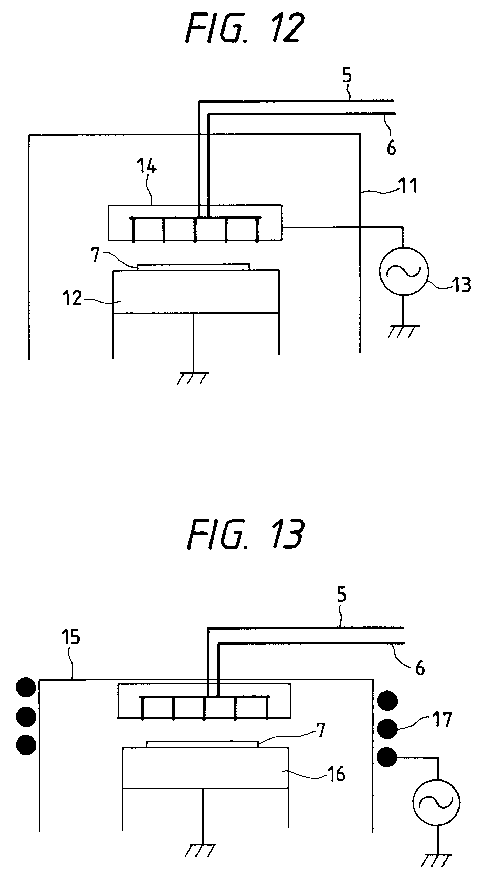

Fig. 12 illustrates schematically the cross-section of a parallel plate type RF (RF: radio frequency)-CVD apparatus for forming an SiOF film. The apparatus comprises a reaction chamber 11, reaction gas inlets 5 and 6, a holder 12 for holding and heating a substrate 7, and a frequency power source 13 for supplying high frequency waves for plasma generation.

First, a process for forming an SiOF film from SiH₂F₂ and nitrogen monoxide (N₂O) gas using the present apparatus is explained hereinafter.

The film is formed by introducing N₂O gas at a rate of 800 ml/min and SiH₂F₂ at a rate of 200 ml/min through the reaction gas inlets 5 and 6, respectively. The pressure in the reaction chamber 3 is adjusted at 200 Pa by controlling the amount of the exhaust gas (the exhaust gas system is not shown in the figure). The SiOF film is formed on a substrate by generating plasma by supplying high frequency waves of 13.6 MHz at 400 W to the upper electrode 14, and reacting N₂O with SiH₂F₂. The temperature of the substrate is kept at 350 °C.

When SiF₄ is used, the film is scarcely formed. However, when SiH₂F₂ is used, the film can be formed with a deposition rate D.R. of 0.20 µm/min. When O₂ is used instead of N₂O with SiH₂F₂, the SiOF film can be formed, but the deposition rate D.R. is less than 0.1 µm/min. The film is scarcely formed when SiF₄ is used, because the bond energy of Si-F is large. However, the SiOF film can be formed by RF plasma using SiH₂F₂, because SiH₂F₂ has Si-H bonds of weak bond energy.

As explained above, the deposition rate is increased by using N₂O instead of O₂, because N₂O has a lower generation energy of active oxygen than O₂. The dielectric constant ε of the formed SiOF film is approximately 3.2.

As described above, the SiOF film having a low dielectric constant can be formed by RF plasma when SiH₂F₂ is used.

### Embodiment 5

Fig. 13 illustrates schematically a cross-section of an ICP (ICP: Inductively Coupled Plasma)-CVD apparatus for forming an SiOF film. The apparatus comprises a reaction chamber 15 made of quartz, reaction gas inlets 5, 6, a holder 16 for holding a substrate 7, and a coil 17 for supplying high frequency waves for plasma generation.

First, in order to compare with the present invention, a process for forming SiOF film using SiF₄ and oxygen gas is explained hereinafter. From the reaction gas inlets 5 and 6, O₂ at a rate of 200 ml/min and SiF₄ at a rate of 40 ml/min are respectively introduced into the reaction chamber 15. The pressure in the reaction chamber 15 is adjusted at 0.2 Pa by controlling the amount of exhaust gas (the exhaust gas system is not shown in the figure). Plasma is generated by supplying high frequency waves of 13.6 MHz at 1 kW to the coil 17 so that the SiOF film is formed on the surface of the substrate by reaction of O₂ and SiF₄. The film deposition rate D.R. is 0.2 µm/min, and the specific dielectric constant ε of the formed film is approximately 3.5. The bonding conditions of the formed film are such that the Si-Si bonds are 10 % of O-Si-O bonds, and Si-O-F bonds are 30 % of the Si-F bonds.

Next, a method for forming an SiOF film by introducing silane difluoride (SiH₂F₂), an embodiment of the present invention, is explained hereinafter. The other conditions for forming the film except the introduced gas are same as in the above-explained process which uses SiF₄. The film deposition rate D.R. is 0.38 µm/min, and is approximately twice of the case of using SiF₄. The increase of the film deposition rate is by the reason that the dissociation energy of the SiH₂F₂ is lower than that of the SiF₄.

Regarding to the infrared absorption spectra of SiOF films formed by SiH₂F₂ and SiF₄, in a case of SiF₄ as same as the ECR plasma, the center of Si-O vibration is 1065 cm⁻¹, and the half width at half height (HWHH) at a lower wave number side is 33 cm⁻¹. Although slightly, moisture (O-H) can be observed. On the other hand, in a case of SiH₂F₂ (case: A), the center of Si-O vibration is 1080 cm⁻¹, and the half width at half height (HWHH) at a lower wave number side is 24 cm⁻¹.

Furthermore, any Si-Si bond and Si-O-F bond can not be observed in the film formed by SiH₂F₂. Accordingly, the structure of the film is mostly composed of Si-O bond and Si-F bond. The reason why O-H bond is not observed in the infrared spectrum is because the structure does not contain weak bond of Si-O-F. Further, the ε is approximately 3.2 as same as the embodiment 4, and the film having a low dielectric constant can be formed. Furthermore, the film formed in the present embodiment has preferable chemical stability.

As explained above, the SiOF film having a low dielectric constant can be formed by ICP plasma if silane difluoride (SiH₂F₂) is used.

### Embodiment 6

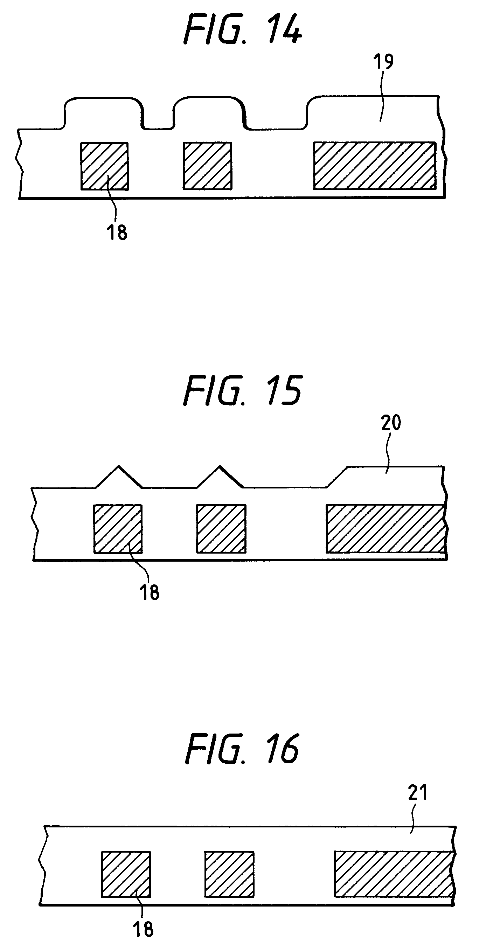

In the above described respective embodiments, when wiring 18 provided on the surface of the semiconductor substrate of the semiconductor device is coated with the SiOF film 19 as shown in Fig. 14, the width of concave portion on the surface of the formed film becomes narrower than the width of the interval between the wiring. Therefore, when a second wiring is formed on the film for multilayers wiring, breaking fraction of wire of the second wiring increases and accordingly, production yield of the semiconductor device decreases. In order to prevent the above decrease of the production yield, the sputtering must be overlapped in forming the SiOF film using SiH₄ and O₂.

As a reference example for forming the film by overlapping the sputtering, a case of forming SiO₂ film with SiH₄ instead of SiF₄ by the apparatus shown in Fig. 10 is explained hereinafter. However, in the above case, high frequency waves of 400 kHz and 400 W are supplied to the substrate from a high frequency power source 9, and other conditions are made as same as the embodiment 1.

The film deposition rate (D.R.) is 0.38 µm/min when the sputtering is not overlapped, and the film deposition rate when the sputterings are overlapped is 0.27 µm/min, corresponding to a 30 % reduction. The reduced amount of the film deposition is the sputtering rate (S.R.), and, in the above case, the S.R. is 0.11 µm/min. The film forming condition in the above case is shown in Fig. 15. The film forming condition is determined by the ratio of D.R. and S.R. The D.R. can be increased by increasing the amount of introduced SiH₄, but the S.R. can not be increased even if the amount of O₂ is increased. The specific dielectric constant ε of the formed film is approximately 4.0.

On the other hand, when SiOF film is formed with SiH₂F₂ and O₂, an embodiment of the present invention, the film deposition rate (D.R.) when the sputterings are not overlapped, is 0.38 µm/min, and the D.R. when the sputterings are overlapped is 0.19 µm/min, 50 % reduction. The reduced amount of 0.19 µm/min is S.R., and is larger than the S.R. in the case when SiH₄ is used. The remarkable increase in the sputtering rate (S.R.) when the sputterings are overlapped is caused by etching of the film by F of SiH₂F₂. Therefore, D.R. can be increased by increasing the introducing amount of SiH₂F₂ as much as the increasing amount of the S.R. In accordance with the method explained above, wherein the amount of introducing SiH₂F₂ is controlled so as to obtain D.R. of 0.66 µm/min, a film is formed on the surface of the wiring, i.e. when a film is formed on the surface of the wiring with an effective deposition rate of 0.66 µm/min, the film is formed in a condition as shown in Fig. 15. In the above case, the specific dielectric constant ε of the formed film is approximately 3.2.

As explained above, if a film is formed with SiH₂F₂ by overlapping the sputtering, not only a film having a low specific dielectric constant can be formed, but also the effective film deposition rate can be increased without increasing power source of the apparatus and others.

Furthermore, in order to decrase the breaking fraction of wire of the second wiring and improve the production yield, a film structure shown in Fig. 16 may be formed by applying a flattening film, or eliminating extra protrusion of the film by etching back, after forming the film shaped as shown in Fig. 15. Instead of the etching back, mechanical-chemical polishing (CMP) can be used.

### Embodiment 7

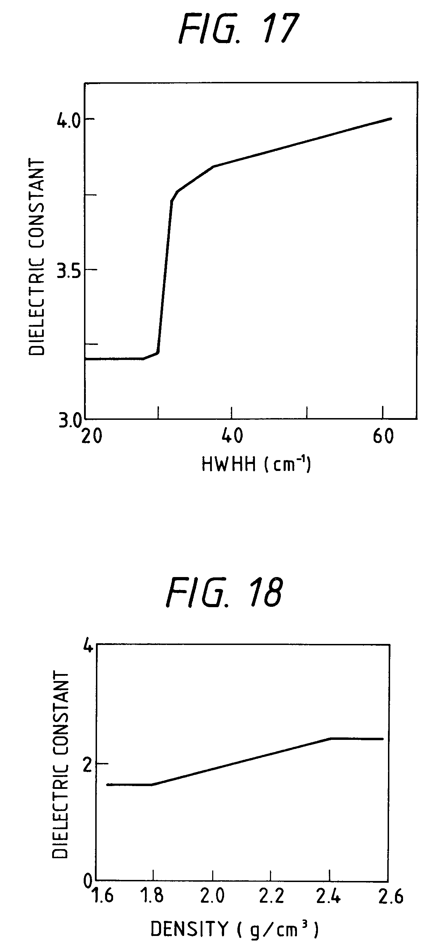

Fig. 17 is a graph indicating a result of the investigation performed by the present inventor. A relationship between dielectric constant ε of SiOF film formed under various forming conditions and the half width at half height (HWHH) at a lower wave number side of Si-O peak in infrared spectrum. The result reveals that there is a strong correlation between the ε and the HWHH. In order to form a SiOF film having a low dielectric constant, a film having the half width at half height (HWHH) at a lower wave number side of Si-O peak in infrared spectrum of less than 30 cm⁻¹ must be formed.

### Embodiment 8

Breakdown voltage (B.V.) of the SiOF film formed with SiF₄ in embodiment 1 is approximately 5 MV/cm. Generally, the breakdown voltage (B.V.) of conventional SiOF film is 9 MV/cm. The breakdown voltage can be improved by forming a film having an intermediate composition between the above described SiOF film and the conventional SiO₂ film.

As a reference example, there is a film forming method using SiH₄, 20 ml/min, and SiF₄, 20 ml/min, instead of SiF₄, 40 ml/min, in embodiment 1. In this case, the film deposition rate (D.R.) of the film is 0.19 µm/min. If the composition of the formed film is in the range between the SiOF film and the conventional SiO₂ film, the specific dielectric constant ε of the film is a value of approximately 3.75. However, ε of the SiOF film formed with SiF₄ is approximately 3.9. That means, fluorine doping can hardly be achieved even if SiF₄ is used as doping gas of fluorine, F. Because the bond energy of the Si-F bond in SiF₄ is significantly larger than the bond energy of the Si-H bond in SiH₄, and the energy introduced into the plasma is hardly used for the dissociation of SiF₄, but used for the dissociation of SiH₄.

On the other hand, there is a film forming method wherein SiH₄, 20 ml/min, and SiH₂F₂, 20 ml/min, are used instead of SiF₄, 40 ml/min, in embodiment 1 of the present invention. In this case, film deposition rate (D.R.) of the film is 0.38 µm/min. The specific dielectric constant of the formed film was approximately 3.75. That means, the composition of the formed film is in an intermediate of the SiOF film and the conventional SiO₂ film. Because, bond energy of Si-H bond in SiH₂F₂ is almost similar with the Si-F bond in SiF₄, and the energy introduced into plasma is used evenly for dissociation of both SiH₂F₂ and SiH₄. The specific dielectric constant ε in a range of 3.2 - 4.0 varies as a primary function of flow rate ratio (SiH₂F₂/SiH₄). Therefore, the specific dielectric constant can be controlled readily.

As explained above, SiH₂F₂ is further preferable for doping of fluorine.

### Embodiment 9

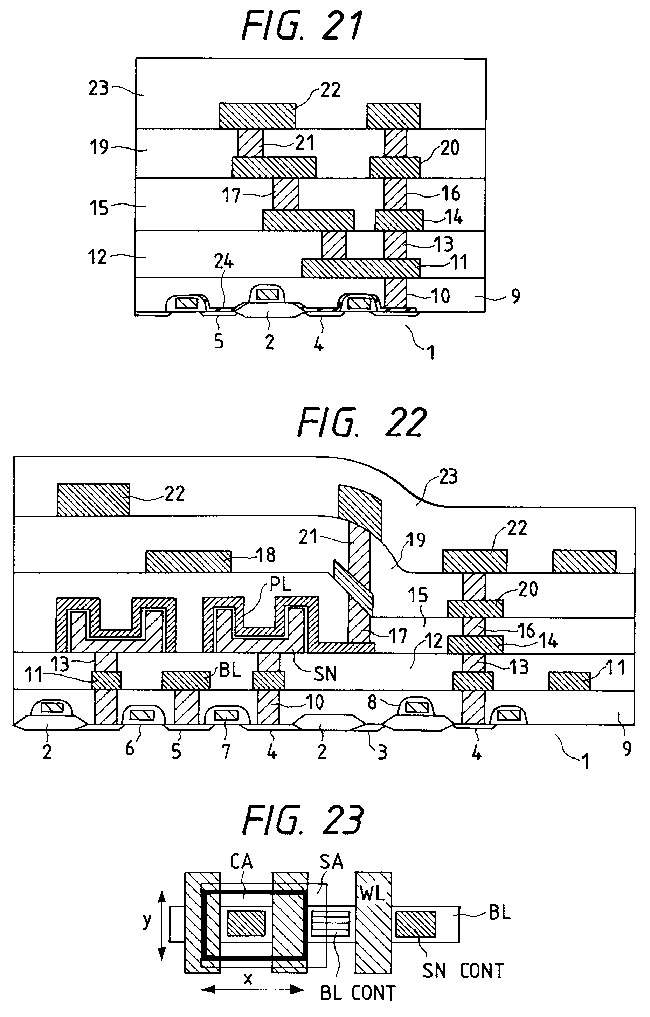

Fig. 21 illustrates schematically a cross-sectional view of a SRAM using an insulator film manufactured by the present invention. The SRAM is manufactured by the following process.

After forming a field oxide film 2 on a p-type silicon substrate 1 by a selective oxide method (LOCOS), a first transistor having a gate 7 and n-type diffused layer 4, 5, and a second transistor adjacent to the first transistor holding the field oxide film 2 between are formed at predetermined locations. Subsequently, a titanium silicide (TiSi₂) film 24 which composes local wiring is formed on the diffused layer 4, 5. Unnecessary portion of the titanium silicide film 24 is eliminated by photolithography and etching. Then, an insulator film such as silicon oxide film (BSPG) containing phosphorus and boron is formed on whole surface of the substrate. A step difference of the insulator film is made gentle by re-flow at 750 °C. Subsequently, an SiO₂ film is formed at 450 °C by a plasma CVD method. A planarized passivation insulator film 9 is composed of a BPSG film on the silicon substrate and an SiO₂ film on the BPSG film. The insulator film 9 formed with chemical mechanical polishing (CMP) process. Further, contact holes are formed on the titanium silicide (TiSi₂) film 24 by photolithography and etching. Bit lines made of tungsten and connecting plugs of wiring layer are formed in the contact holes. Next, a pad for connecting lead wire and a first layer of the wiring layer 11 are formed.

After forming the wiring layer 11, an SiOF film (specific dielectric constant is 3.3) is formed on the whole surface of the substrate by a plasma CVD method using SiH₂F₂. The first layer of the planarized insulator film 12 is formed by treating the SiOF film with a chemical mechanical polishing (CMP) process. The contact holes are formed on the planarized insulator film 12, and plugs 16, 17 made of tungsten are formed in the contact holes. Subsequently, after forming a second layer of the wiring layer 14 is formed, an insulator film 15 composed of the SiOF film is formed using SiH₂F₂. Through holes and the plugs 16, 17 made of tungsten are formed on the insulator film 15.

Consecutively, by the same process as the above, a third layer of the wiring layer 20, a third layer of the planarized insulator film 19, plugs 21, a fourth layer of the wiring layer 22, and a fourth layer of the planarized insulator film 23 are formed, respectively.

In accordance with an investigation by the present inventor, a signal delay time of the above SRAM is 22 ps. On the contrary, the signal delay time of the insulator film composed of the SiO₂ film which is formed with SiH₄ is 28 ps, and the signal delay time of the insulator film composed of the SiOF film which is formed with SiF₄ is 25 ps. In an accelerated test equivalent to 100,000 hours, the signal delay time of conventional SRAM fluctuates significantly in a range of 22-36 ps, but the signal delay time of the SRAM of the present invention scarcely changes. Accordingly, signal delay of the SRAM can be decreased and reliability of the SRAM can be improved by using the SiOF film formed with SiH₂F₂ as the insulator film among wiring. The above advantage becomes more significant when the integration of the SRAM is increased, and the distance between the wires becomes finer.

Fig. 22 illustrates schematically a cross-sectional view of a DRAM using an insulator film manufactured according to the present invention. Fig. 23 is a plan view of a memory cell of the DRAM. In these figures, BL and WL indicate respectively a bit line and a word line. Furthermore, SN cont., and BL cont. indicate respectively a connecting portion to a storage node and a connecting portion to the bit line. SA indicates the memory cell and its shadow area, and X and Y indicate sizes of the memory cell. In a case of 256 Mbit DRAM, x and y are respectively 0.85 µm and 0.65 µm. The DRAM is manufactured by the following process.

After forming a field oxide film 2 on a p-type silicon substrate 1 by a selective oxide method (LOCOS), a first transistor having a gate 7 and n-type diffused layer 4, 5, and a second transistor adjacent to the first transistor holding the field oxide film 2 between are formed at predetermined locations. Subsequently, an insulator film such as silicon oxide film (BSPG) containing phoshorus and boron is formed on whole surface of the substrate. Then, an SiO₂ film is formed by a plasma CVD method. A planarized passivation insulator film 9 is formed by treating a multilayer body composed of the SiO₂ film and the insulator film with a chemical mechanical polishing (CMP) process. Further, contact holes are formed on the planarized passivation insulator film 9. A connecting plug made of phosphorus doped silicon for being connected to the bit line BL, the storage node SN, and the first layer of the wiring layer is formed in the contact holes. Next, a pad for being connected to the bit line BL and the storage node SN and the wiring layer 11 are formed. Both the pad and the wiring layer have a multilayer structure of TiN/Al/TiN, and are formed simultaneously.

After forming the wiring layer 11, an SiOF film is formed on the whole surface of the substrate by a plasma CVD method using SiH₂F₂. The first layer of the planarized insulator film 12 is formed by treating the SiOF film with a chemical mechanical polishing (CMP) process. The contact holes are formed on the planarized insulator film 12, and plugs 13, 14 made of tungsten are formed in the contact holes.

Subsequently, a capacitor is formed. Size of projected area of the capacitor formed portion is 0.65 µm x 0.65 µm. The capacitor has a cylindrical structure of 0.5 µm high in order to increase charge storage capacity. The capacitor is formed by the following process.

A lower electrode of the storage node SN is formed from tungsten film of 0.5 µm thick, which is formed by a CVD method, by manufacturing with photolithography and dry etching. Next, in order to form side electrode of the storage node SN, a SiO₂ film of 0.3 µm thick is deposited. The SiO₂ film is manufactured to a columnar block of 0.4 µm x 0.4 µm by photolithography and dry etching. A tungsten film of 0.2 µm thick is formed on the columnar block by a CVD method. The tungsten film is manufactured to side walls of the storage node SN by etching back. Unnecessary columnar block is eliminated by wet etching. Subsequently, a tantalum pentaoxide (Ta₂O₅) film is formed by a CVD method, and unnecessary portion of the tantalum pentaoxide film is eliminated by photolithography and dry etching. Next, a titanium nitride (TiN) film of 0.2 µm thick is formed on whole surface. A plate electrode PL is formed by etching back after a plate electrode PL lead out portion of the titanium nitride film is coated with resist by photolithography. At this time, a capacitor of 0.5 µm x 0.5 µm is formed on the plug 14. Next, after forming a TiN film, an Al film, and a TiN film orderly, a wiring layer of periphery circuit is formed by manufacturing the multilayer body with photolithography and dry etching.

Subsequently, an insulator film is formed in order to protect the capacitor and to insulate the second layer of the wiring layer. The insulator film is composed of an oxide film formed with organic silane. Next, through holes and the plugs 16, 17 made of tungsten are formed. By a method using selective growing of tungsten, it becomes possible to form the plugs 16, 17 having respectively different height as shown in Fig. 22.

Next, the third layer of the wiring layer 18 and the pad 19 are formed. Further, the third layer of the planarized SiOF insulator film 20 is formed by the method previously described. Subsequently, in accordance with the above described steps, the plug 21, the fourth layer of the wiring layer 22, and the fourth planarized insulator layer 23 are formed.

According to an investigation by the present inventor, a fraction defective in 200 hours' pressure cooker test of the above described DRAM relating to the present invention is 3 %. On the contrary, when the insulator film is the SiOF film formed with SiH₄, the fraction defective is approximately 38 %, and when the insulator film is the SiOF film formed with SiF₄, the fraction defective is approximately 62 %. Accordingly, the reliability of the DRAM can be increased by using the SiOF film formed with SiH₂F₂ as the insulator film.

Furthermore, the present inventor examined TFT characteristics of a TFT using the SiOF film formed with SiH₂F₂ as a gate insulator film of a TFT-LCD, and of a TFT using the SiO₂ film formed with conventional SiH₄. In accordance with the result, the mobility µ in the case using SiOF film is approximately 0.6 cm²/V·s, and the mobility µ in the case using SiO₂ film is approximately 0.4 cm²/V·s. The difference in µ as above described is caused by fluorine isolated in plasma when SiH₂F₂ is used, which flattens the surface of the formed film.

The SiOF film is preferable as a passivation film for LSI, power transistor, and TFT, because it is hydrophobic.

### Embodiment 10

The present inventors investigated the SiOF film manufactured with the same apparatus and method as in embodiment 1 under various reaction pressure, input power, and gas flow rate. Results of the investigation are explained hereinafter.

Fig. 18 is a graph indicating the relationship between the specific dielectric constant and the densitiy of the formed film. The specific dielectric constant depends on the density, and especially, the specific dielectric constant can be expressed approximately by a primary function of the density when the density is in a range of 1.8-2.4 g/cm³. That means, the dielectric constant can be decreased by lowering the density.

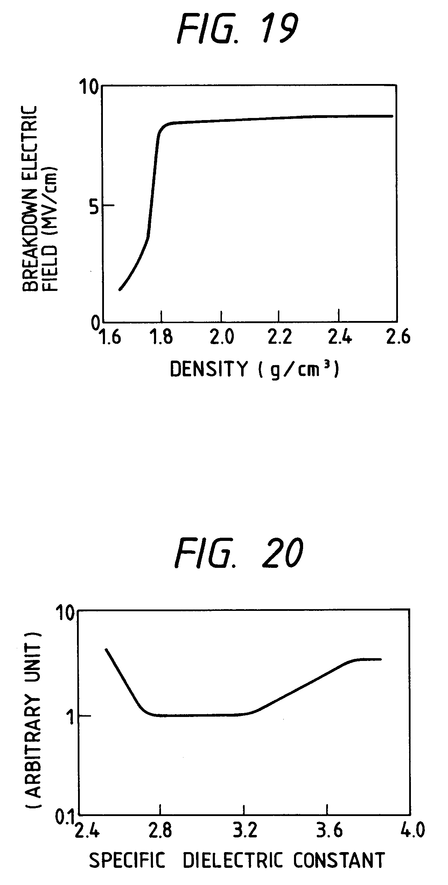

Fig. 19 is a graph indicating the relationship between breakdown voltage and density of the formed film. The film has a sufficient breakdown voltage as an insulator film between wires in a region where the density is larger than 1.8 g/cm³.

As explained above, the SiOF film having a density in the range of 1.8-2.4 g/cm³ is preferable as an insulator film of low dielectric constant.

### Embodiment 11

Results of investigations by the present inventors on the desorption amount of the SiOF film in embodiment 10 are explained hereinafter.

Fig. 20 indicates the relationship between the specific dielectric constant of the formed film and the desorption amount of the film when the film is heated at 600 °C. The value of the desorption amount is normalized with the specific dielectric constant of the film formed with SiH₂F₂ in embodiment 1. As Fig. 20 indicates, when the specific dielectric constant is in a range of 2.8-3.2, the desorption amount is a constant. However, when the specific dielectric constant is less than 2.8 or larger than 3.2, the desorption amount increases. When the specific dielectric constant is less than 2.8, coarse portions of the film material is generated in the formed film because of low density, and moisture in air is taken into the coarse portions. Consequently, the desorption amount increases. When the specific dielectric constant is larger than 3.2, moisture in air or hydroxide group in moisture is readily taken into the film because of existing O-F bond Si-Si bond. Consequently, the desorption amount increases.

As explained above, in order to decrease moisture content of the film, use of the film having the specific dielectric constant in a range of 2.8-3.2 is preferable. By using such a film as described above, reliability of semiconductor devices such as LSI and the like can be improved.

SiNF film can be formed by using nitration gas such as N₂, or NH₃ instead of oxidation gas. When an SiN film formed with SiH₂F₂ and nitration gas such as N₂, or NH₃ is used as a TFT gate film, more preferable characteristics can be obtained than a TFT using an SiN film formed with SiH₄ as a gate film. As explained above, SiH₂F₂ is preferable for forming a gate insulator film of semiconductor.

In accordance with the present invention, a dielectric film having a low dielectric constant and high reliability can be formed, and consequently, a semiconductor device of less wiring delay of signal and a semiconductor device having preferable characteristics can be manufactured. Because the dielectric film having a low dielectric constant and high reliability can be formed effectively, such an advantage as reducing manufacturing cost of the semiconductor devices can be realized.

## Claims

1. A dielectric comprising a silicon oxide fluoride compound having a covalent bond between a fluorine atom and a silicon atom.

2. Dielectric according to claim 1, wherein the silicon oxide fluoride compound has an additional covalent bond between the silicon atom and an oxygen atom.

3. Dielectric according to claim 1 and/or 2, which has a half width at half height of equal to or less than 30 cm⁻¹ at a region in the low frequency range of the infrared spectrum.

4. Dielectric according to one or several of claims 1 to 3, which has a density in a range of 1.8-2.4 g/cm³.

5. Dielectric according to one or several of claims 1 to 4, which has a dielectric constant in the range of 2.8-3.2.

6. A method for manufacturing a dielectric particularly those of claims 1 to 5, comprising the following steps: introducing a gas containing SiF₂X₂ gas onto a substrate, and supplying energy to the gas which does not lead to a dissociation of the covalent bonds between the fluorine atoms and the silicon atoms in the SiF₂X₂.

7. The method according to claim 6, wherein an SiF₂X₂ compound is used wherein X is selected from H, Cl, Br, OCH₃, OC₂H₅, and OC₃H₇.

8. The method according to claim 6 and/or 7, wherein said energy supplied is less than 541 kJ per 1 mol of SiF₂X₂.

9. The method according to one or several of claims 6 to 8, wherein the energy is supplied by means of a CVD apparatus.

10. The method according to one or several of claims 6 to 8, wherein the energy is supplied by means of a plasma treating apparatus.

11. The method according to one or several of claims 6 to 8, wherein overlapping sputtering processes are applied.

12. The method according to claim 10, wherein the plasma is generated by radio waves.

13. Dielectric according to one or several of claims 1 to 5, obtainable according to the methods of claims 6 to 12.

14. Semiconductor device, comprising
a plurality of wirings located on the surface of a semiconductor substrate, and
a dielectric located at the intervals between the wirings, characterized in that the dielectric is a dielectric according to one of claims 1 to 5 and 13.

15. Semiconductor device, particularly according to claim 14, comprising
a plurality of wirings located on the surface of a semiconductor substrate, and
a dielectric comprising a silicon oxide fluoride compound, which has a half width at half height of equal to or less than 30 cm⁻¹ in the low frequency region of the infrared spectrum.

16. Use of the dielectric according to claims 1 to 5 for manufacturing LSIs power transistors, TFTs and similar semiconductor elements and circuits.
